Europäisches Patentamt

European Patent Office

Office européen des brevets

(19)

(11) Veröffentlichungsnummer: **0 171 687**

A1

(12) **EUROPÄISCHE PATENTANMELDUNG**

(21) Anmeldenummer: 85109429.2

(22) Anmeldetag: 26.07.85

(51) Int. Cl.⁴: **H 05 K 7/14**

(30) Priorität: 07.08.84 DE 3429020

(43) Veröffentlichungstag der Anmeldung:
19.02.86 Patentblatt 86/8

(84) Benannte Vertragsstaaten:
AT BE CH DE FR GB IT LI LU NL SE

(71) Anmelder: i f m electronic gmbh
Teichstrasse 4
D-4300 Essen 1(DE)

(72) Erfinder: Friedrich, Michael B., Ing. grad.
Rosenstrasse 10
D-7993 Kressbronn(DE)

(72) Erfinder: Buck, Robert
Vogelherdbogen 67
D-7992 Tettnang(DE)

(72) Erfinder: Marhofer, Gerd
Beckmannsbusch 67
D-4300 Essen-Bredeney(DE)

(74) Vertreter: Gesthuysen, Hans Dieter, Dipl.-Ing. et al,
Patentanwälte Gesthuysen + von Rohr Huyssenallee 15
Postfach 10 13 33
D-4300 Essen 1(DE)

(54) Programmierbare Steuerung.

(57) Dargestellt und beschrieben ist eine programmierbare Steuerung mit einem Montageelement (1), einem Netzteil (2), einer Zentraleinheit (3) und einem Eingangs- und Ausgangsmodul (4).

Ein gelungener elektrischer und mechanischer Aufbau der dargestellten programmierbaren Steuerung ist dadurch erreicht, daß das Netzteil (2) in und/oder auf dem Montageelement (1), die Zentraleinheit (3) in und/oder auf dem Netzteil (2) und der Eingangs- und Ausgangsmodul (4) in und/oder auf der Zentraleinheit (3) angeordnet sind.

EP 0 171 687 A1

./...

Croydon Printing Company Ltd.

Fig.1

**0171687**

Die Erfindung betrifft eine programmierbare Steuerung, mit einem Montageelement, einem Netzteil, einer Zentraleinheit und einem Eingangs- und Ausgangsmodul.

Programmierbare Steuerungen der zuvor in ihrem grundsätzlichen - elektrischen bzw. elektronischen - Aufbau skizzierten Art sind mittlerweile seit mehreren Jahren in einer Vielzahl von Ausführungsformen bekannt. Eine kritische Betrachtung dieser programmierbaren Steuerungen zeigt, daß die Fachwelt viel erfinderisches Bemühen hinsichtlich des elektronischen Aufbaus solcher programmierbarer Steuerungen aufgewandt hat, daß der elektrische Aufbau, insbesondere aber auch der mechanische Aufbau dieser Steuerungen gleichsam stiefmütterlich behandelt worden ist.

Der Erfindung liegt folglich die Aufgabe zugrunde, eine programmierbare Steuerung anzugeben, die sich durch einen gelungenen elektrischen und mechanischen Aufbau auszeichnet.

Die erfindungsgemäße programmierbare Steuerung, bei der die zuvor dargelegte Aufgabe gelöst ist, ist zunächst und im wesentlichen dadurch gekennzeichnet, daß das Netzteil in und/oder auf dem Montageelement, die Zentraleinheit in und/ oder auf dem Netzteil und der Eingangs- und Ausgangsmodul in und/oder auf der Zentraleinheit angeordnet sind.

Erfindungsgemäß ist also in elektrischer und mechanischer Hinsicht ein modularer Aufbau einer programmierbaren Steuerung verwirklicht, während im Stand der Technik ein modularer Aufbau nur in elektronischer Hinsicht bekannt ist, insbesondere ein modularer Aufbau der Zentraleinheit sowie ein modularer Aufbau des Eingangs- und Ausgangsmoduls.

Der bei der erfindungsgemäßen programmierbaren Steuerung verwirklichte modulare Aufbau in elektrischer und mechanischer Hinsicht hat eine Vielzahl von Vorteilen. Ein erster wesentlicher Vorteil ist darin zu sehen, daß unterschiedliche Montage-

- 1 -

elemente, unterschiedliche Netzteile, unterschiedliche Zentraleinheiten und unterschiedliche Eingangs- und Ausgangsmodule zu unterschiedlichen programmierbaren Steuerungen zusammengesetzt werden können. Erheblich ist der weitere Vorteil, daß zuerst der - mechanisch und elektrisch - am wenigsten empfindliche Modul, nämlich das Montageelement, montiert und angeschlossen werden kann, um dann erst später, praktisch unmittelbar vor der Inbetriebnahme, die empfindlicheren Module, insbesondere die Zentraleinheit und den Eingangs- und Ausgangsmodul, zu installieren. Schließlich ist ein ganz entscheidender Vorteil darin zu sehen, daß ein austauschgerechter Aufbau realisiert ist. Austauschgerechter Aufbau meint die Tatsache, daß die einzelnen Module der erfindungsgemäßen programmierbaren Steuerung hierarchisch von oben nach unten entsprechend der Ausfallwahrscheinlichkeit und Austauschnotwendigkeit angeordnet sind. Dem hierarchischen Aufbau von oben nach unten - Eingangs- und Ausgangsmodul, Zentraleinheit, Netzteil und Montageelement - liegt die Erkenntnis zugrunde, daß bei Ausfällen und damit notwendigerweise verbundenem Austausch in ca. 90 von 100 Fällen der Ein- und Ausgangsmodul betroffen ist.

Im folgenden werden die Lehre der Erfindung sowie Ausgestaltungen und Weiterbildungen der Lehre der Erfindung anhand von zeichnerisch dargestellten Ausführungsbeispielen näher erläutert; es zeigt

Fig. 1   schematisch, perspektivisch und in sogenannter Sprengdarstellung, ein erstes Ausführungsbeispiel einer erfindungsgemäßen programmierbaren Steuerung,

Fig. 2   perspektivisch, eine Ansicht eines zweiten Ausführungsbeispiels einer erfindungsgemäßen programmierbaren Steuerung,

Fig. 3   den Gegenstand nach Fig. 2, teilweise aufgebrochen,

Fig. 4   den Gegenstand nach Fig. 3 in sogenannter Sprengdarstellung und

Fig. 5    einen Längsschnitt durch den Gegenstand nach Fig. 2.

Die in den Figuren dargestellte programmierbare Steuerung besteht in ihrem
grundsätzlichen Aufbau aus einem Montageelement 1, einem Netzteil 2, einer
Zentraleinheit 3 und einem Eingangs- und Ausgangsmodul 4.

Wie die Figuren zeigen, sind das Netzteil 2 in und auf dem Montageelement 1,
die Zentraleinheit 3 auf dem Netzteil 2 und der Eingangs- und Ausgangsmodul 4
auf der Zentraleinheit 3 angeordnet. Erfindungsgemäß ist also in elektrischer
und mechanischer Hinsicht ein modularer Aufbau verwirklicht. Dabei ist dieser
Aufbau hierarchisch von oben nach unten entsprechend der Ausfallwahrscheinlichkeit und Austauschnotwendigkeit, also von oben nach unten Eingangs- und Ausgangsmodul 4, Zentraleinheit 3, Netzteil 2 und Montageelement 1.

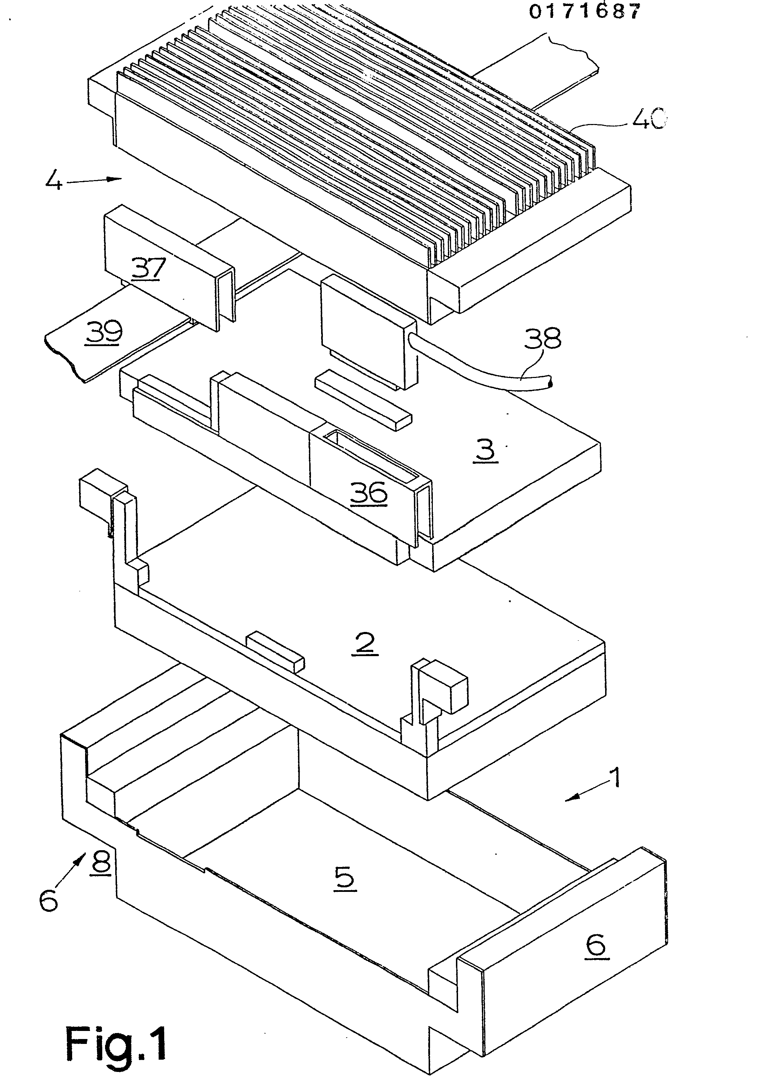

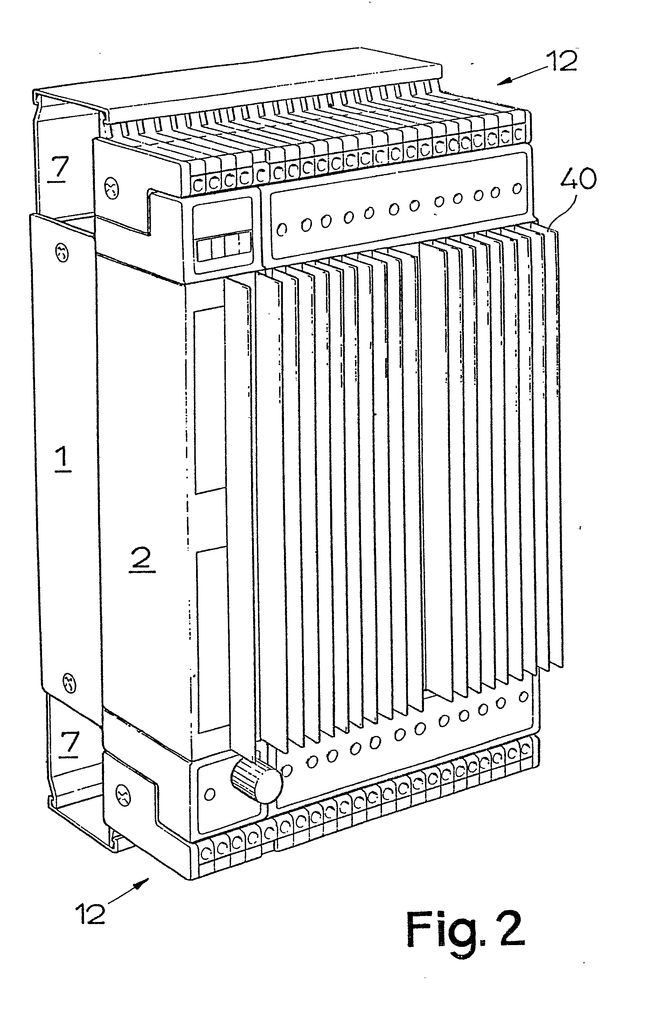

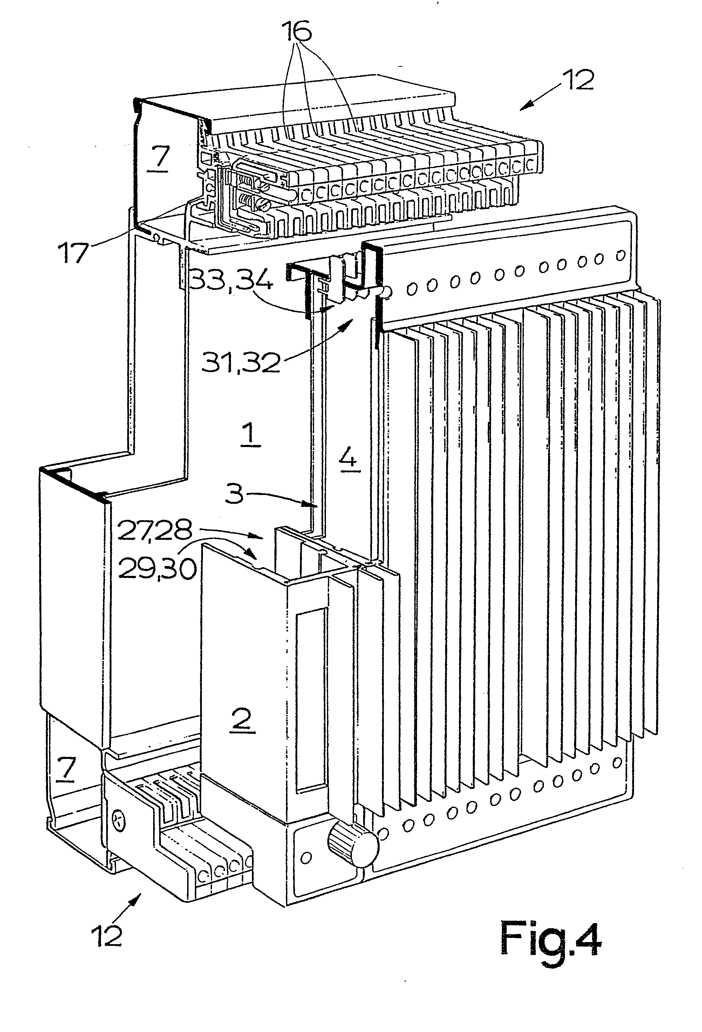

In den Ausführungsbeispielen, die in den Figuren dargestellt sind, ist das
Montageelement 1 wannenförmig und darüberhinaus im Querschnitt U-förmig ausgeführt, wobei das wannenförmige Bodenteil 5 den U-Steg und die Seitenteile 6
die U-Schenkel darstellen. Im übrigen weist das Montageelement 1 an zwei Seiten,
in Verbindung mit den Seitenteilen 6, Kabelkanäle 7 auf, die gleichsam - hinsichtlich der Gesamtkonfiguration des Montageelementes 1 - in das Montageelement 1 integriert sind, - was in Fig. 1 nicht dargestellt ist, den Fig. 2 bis 5
jedoch besonders gut entnommen werden kann.

Wie die Fig. 2 bis 5 im einzelnen zeigen, weist das Montageelement 1 im Bereich
der Seitenteile 6 jeweils eine im Querschnitt rechteckige Ausnehmung 8 auf und
sind im Bereich der rechteckigen Ausnehmungen 8 die Kabelkanäle 7 realisiert.

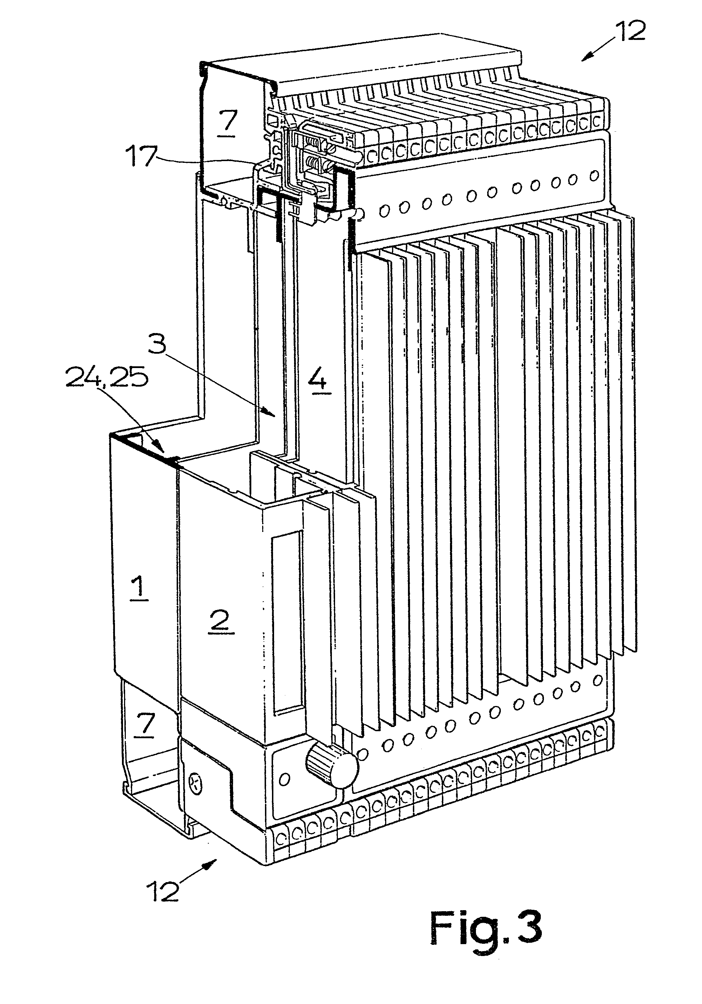

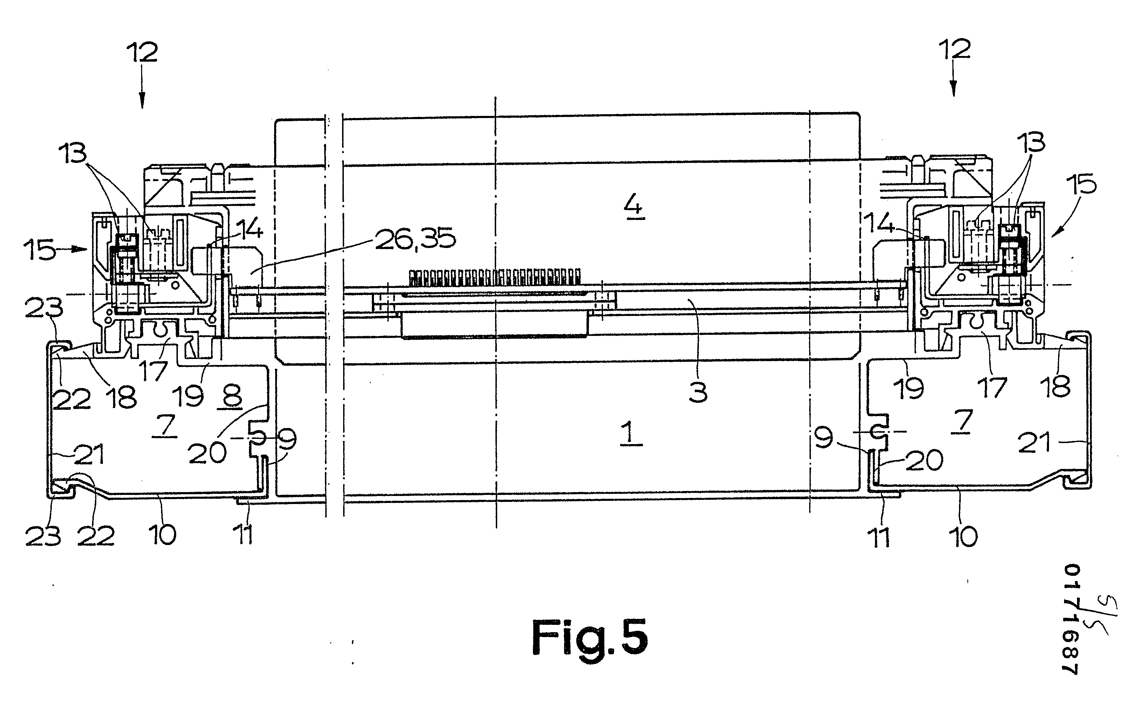

Im Ausführungsbeispiel, das in den Fig. 2 bis 5 dargestellt ist, weist das Montageelement 1 im Bereich beider Seitenteile 6 jeweils eine Aufnahmenut 9 für
ein erstes Kabelkanalelement 10 auf. Unterhalb und rechtwinklig zu der Aufnahmenut 9 ist jeweils ein Abstützsteg 11 verwirklicht. Wiederum nur den Fig. 2 bis 5,

- 3 -

insbesondere der Fig. 5, kann entnommen werden, daß im dargestellten Ausführungsbeispiel das Montageelement 1 im Bereich beider Seitenteile 6 eine Anschlußleiste 12 mit mehreren jeweils ein externes Anschlußelement 13 und ein internes Anschlußelement 14 aufweisenden Anschlußstellen 15 aufweist. Dabei ist jede Anschlußleiste 15 oberhalb eines Kabelkanals 7 vorgesehen und besteht jede Anschlußleiste 15 aus einer Mehrzahl von - aneinandergereihten - Anschlußklemmen 16. Insbesondere die Fig. 5 zeigt, daß jede Anschlußleiste 12 zwei hintereinanderliegende Reihen von Anschlußstellen 15 aufweist; jede Anschlußklemme 16 hat also zwei Anschlußstellen 15, d. h. zwei externe Anschlußelemente 13 und zwei interne Anschlußelemente 14. Im dargestellten Ausführungsbeispiel sind die externen Anschlußelemente 13 als Schraubanschlüsse ausgeführt; sie könnten ohne weiteres auch als Federkraftanschlüsse, Lötanschlüsse, Termipointanschlüsse und/oder Wirewrapanschlüsse ausgeführt sein. Die internen Anschlußelemente 14 sind, wie der Fig. 5 entnommen werden kann, als Messerkontaktanschlüsse, also gabelförmig ausgeführt. Den Fig. 3 bis 5, insbesondere wiederum der Fig. 5, kann entnommen werden, daß in dem in den Fig. 2 bis 4 dargestellten Ausführungsbeispiel das Montageelement 1 im Bereich beider Seitenteile 6 jeweils eine angeformte Tragschiene 17 für die Anschlußleisten 12 aufweist. Bei dieser Ausführungsform sind die beiden Kabelkanäle 7 auch jeweils durch die angeformte Tragschiene 17 gebildet.

Nur der Fig. 5 kann entnommen werden, daß im dargestellten Ausführungsbeispiel die Anschlußklemmen 16 nach außen ragende Kabelkanalelemente 18 aufweisen. Hier sind also die Kabelkanäle 7 durch die die jeweilige Ausnehmung 8 im Montageelement 1 definierenden Begrenzungsflächen 19, 20, durch das erste Kabelkanalelement 10, durch die an den Anschlußklemmen 16 verwirklichten Kabelkanalelemente 18 und durch ein weiteres Kabelkanalelement 21 gebildet. Im einzelnen weisen dabei das erste Kabelkanalelement 10 und die an den Anschlußklemmen 16 verwirklichten Kabelkanalelemente 18 einerseits sowie das weitere Kabelkanalelement 21 andererseits einander zugeordnete Rastelemente 22, 23 auf.

- 4 -

Die mechanische und elektrische Verbindung der Module Montageelemente 1, Netzteil 2, Zentraleinheit 3 und Eingangs- und Ausgangsmodul 4 ist bei der erfindungsgemäßen, in den Fig. 2 bis 5 dargestellten programmierbaren Steuerung
dadurch realisiert, daß das Montageelement 1 und das Netzteil 2 einander zugeordnete mechanische Verbindungsmittel 24, 25, und zwar in Form von Nuten und
Federn, aufweisen, daß das Netzteil 2 den internen Anschlußelementen 14 der
Anschlußstellen 15 der Anschlußleiste 12 zugeordnete Anschlußelemente 26 aufweist, daß das Netzteil 2 und die Zentraleinheit 3 einander zugeordnete mechanische Verbindungsmittel 27, 28, und zwar in Form von Nuten und Federn, und
einander zugeordnete elektrische Verbindungsmittel 29, 30, und zwar in Form
von Buchsen und Steckern, aufweisen, daß die Zentraleinheit 3 und der Eingangs-
und Ausgangsmodul 4 einander zugeordnete mechanische Verbindungsmittel 31, 32,
und zwar in Form von Nuten und Federn, und einander zugeordnete elektrische
Verbindungsmittel 33, 34, und zwar in Form von Buchsen und Steckern, aufweisen
und daß der Eingangs- und Ausgangsmodul 4 den internen Anschlußelementen 14
der Anschlußstellen 15 der Anschlußleiste 12 zugeordnete Anschlußelemente 35
aufweist. Schließlich zeigen die Fig. noch insoweit bevorzugte Ausführungsbeispiele der erfindungsgemäßen programmierbaren Steuerung, als einerseits die
Zentraleinheit 3 Anschlußelemente 36, 37 zum Anschluß eines Interfacekabels 38
und zum Anschluß eines Buskabels 39 aufweist und der Eingangs- und Ausgangsmodul 4 mit Kühlrippen 40 versehen ist.

- 5 -

0171687

Patentansprüche:

1. Programmierbare Steuerung mit einem Montageelement, einem Netzteil, einer Zentraleinheit und einem Eingangs- und Ausgangsmodul, d a .d u r c h g e k e n n z e i c h n e t, daß das Netzteil (2) in und/oder auf dem Montageelement (1), die Zentraleinheit (3) in und/oder auf dem Netzteil (2) und der Eingangs- und Ausgangsmodul (4) in und/oder auf der Zentraleinheit (3) angeordnet sind.

2. Programmierbare Steuerung nach Anspruch 1, dadurch gekennzeichnet, daß das Montageelement (1) wannenförmig, vorzugsweise im Querschnitt U-förmig ausgeführt ist.

3. Programmierbare Steuerung nach Anspruch 1 oder 2, dadurch gekennzeichnet, daß das Montageelement (1) an wenigstens einer Seite einen Kabelkanal (7) aufweist, vorzugsweise der Kabelkanal (7) in das Montageelement (1) integriert ist, insbesondere das Montageelement an wenigstens einer Seite eine im Querschnitt vorzugsweise rechteckige Ausnehmung (8) aufweist und im Bereich der rechteckigen Ausnehmung (8) der Kabelkanal (7) realisiert ist.

4. Programmierbare Steuerung nach Anspruch 3, dadurch gekennzeichnet, daß das Montageelement (1) wenigstens eine Aufnahmenut (9) für ein erstes Kabelkanalelement (10) aufweist, vorzugsweise die Aufnahmenut und das Kabelkanalelement einander zugeordnete Rasteelemente aufweisen und/oder das Montageelement (1) einen vorzugsweise rechtwinklig zu der Aufnahmenut (9) verlaufenden Abstützsteg (11) aufweist und/oder der Kabelkanal durch die die Ausnehmung im Montageelement definierenden Begrenzungsflächen, durch das erste Kabelkanalelement und durch ein weiteres Kabelkanalelement gebildet ist.

5. Programmierbare Steuerung nach einem der Ansprüche 1 bis 4, dadurch gekennzeichnet, daß das Montageelement (1) an wenigstens einer Seite eine Anschlußleiste (12) mit mehreren jeweils ein externes Anschlußelement (13)

- 1 -

und ein internes Anschlußelement (14) aufweisenden Anschlußstellen (15) aufweist und vorzugsweise die Anschlußleiste (12) oberhalb des Kabelkanals (7) vorgesehen ist und/oder aus einer Mehrzahl von Anschlußklemmen (16) besteht und/oder wenigstens zwei hintereinanderliegende Reihen von Anschlußstellen (15) aufweist.

6. Programmierbare Steuerung nach Anspruch 5, dadurch gekennzeichnet, daß die externen Anschlußelemente (13) als Schraubanschlüsse, Federkraftanschlüsse, Lötanschlüsse, Termipointanschlüsse und/oder Wirewrapanschlüsse ausgeführt sind und/oder die internen Anschlußelemente (14) als Messerkontaktanschlüsse ausgeführt sind.

7. Programmierbare Steuerung nach Anspruch 5 oder 6, dadurch gekennzeichnet, daß das Montageelement (1) an wenigstens einer Seite eine angeformte Tragschiene (17) für die Anschlußleiste (12) aufweist und vorzugsweise der Kabelkanal (7) auch durch die angeformte Tragschiene (17) gebildet ist.

8. Programmierbare Steuerung nach einem der Ansprüche 3 bis 7, dadurch gekennzeichnet, daß die Anschlußleiste bzw. die Anschlußklemmen (16) ein Kabelkanalelement bzw. Kabelkanalelemente (18) aufweisen und vorzugsweise der Kabelkanal (7) durch die die Ausnehmung (8) im Montageelement (1) definierenden Begrenzungsflächen (19, 20), durch das erste Kabelkanalelement (10), durch das an der Anschlußleiste verwirklichte Kabelkanalelement bzw. durch die an den Anschlußklemmen (16) verwirklichten Kabelkanalelemente (18) und durch ein weiteres Kabelekanalelement (21) gebildet ist und vorzugsweise das erste Kabelkanalelement (10) und das an der Anschlußleiste verwirklichte Kabelkanalelement bzw. die an den Anschlußklemmen (16) verwirklichten Kabelkanalelemente (18) einerseits sowie das weitere Kabelkanalelement (21) andererseits einander zugeordnete Rastelemente (22, 23) aufweisen.

9. Programmierbare Steuerung nach einem der Ansprüche 1 bis 8, dadurch gekennzeichnet, daß das Montageelement (1) und das Netzteil (2) einander zugeordnete mechanische Verbindungsmittel (24, 25), vorzugsweise in Form von
Nuten und Federn, aufweisen.

10. Programmierbare Steuerung nach einem der Ansprüche 1 bis 9, dadurch gekennzeichnet, daß das Netzteil (2) den internen Anschlußelementen (14) der
Anschlußstellen (15) der Anschlußleiste (12) zugeordnete Anschlußelemente (26)
aufweist und/oder das Netzteil (2) und die Zentraleinheit (3) einander zugeordnete mechanische Verbindungsmittel (27, 28), vorzugsweise in Form von
Nuten und Federn, und einander zugeordnete elektrische Verbindungsmittel (29,
30), vorzugsweise in Form von Buchsen und Steckern, aufweisen.

11. Programmierbare Steuerung nach einem der Ansprüche 1 bis 10, dadurch gekennzeichnet, daß die Zentraleinheit (3) und der Eingangs- und Ausgangsmodul (4) einander zugeordnete mechanische Verbindungsmittel (31, 32), vorzugsweise in Form von Nuten und Federn, und einander zugeordnete elektrische
Verbindungsmittel (33, 34), vorzugsweise in Form von Buchsen und Steckern
aufweisen und/oder der Eingangs- und Ausgangsmodul (4) den internen Anschlußelementen (14) der Anschlußstellen (15) der Anschlußleiste (12) zugeordnete
Anschlußelemente (35) aufweist.

12. Programmierbare Steuerung nach einem der Ansprüche 1 bis 11, dadurch gekennzeichnet, daß die Zentraleinheit (3) Anschlußelemente (36, 37) zum Anschluß wenigstens eines Interfacekabels (38) und/oder zum Anschluß wenigstens
eines Buskabels (39) aufweist.

13. Programmierbare Steuerung nach einem der Ansprüche 1 bis 12, dadurch gekennzeichnet, daß der Eingangs- und Ausgangsmodul (4) mit Kühlrippen (40)
versehen ist.

Fig.1

Fig. 2

**Fig.3**

Fig.4

**Fig.5**

0171687

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | US-A-4 250 563  (STRUGER)<br>*  Figur 1; Spalte 3, Zeilen 8-56 * | 1 | H 05 K    7/14 |
| Y | | 2,3 | |
| A | | 11,12 | |
| | --- | | |
| Y | GB-A-2 015 264  (UNITED GAS INDUSTRIES)<br>*  Figur 1; Seite 1, Zeilen 53-63 * | 2,3 | |
| | --- | | |
| A | FR-B-2 543 781  (AVE SPA)<br>* Seite 1, Zeilen 24-33 * | 2,5,6 | |
| | --- | | |
| A | DE-B-2 910 600  (FELTEN & GUILLEAUME)<br>* Spalte 2, Zeilen 19-35 * | 1 | RECHERCHIERTE SACHGEBIETE (Int. Cl.4)<br><br>H 05 K<br>G 05 B |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 06-11-1985 | TOUSSAINT F.M.A. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82